# EUROPÄISCHE PATENTSCHRIFT

(11) **EP 3 965 539 B1**
(45) Veröffentlichungstag und Bekanntmachung des Hinweises auf die Patenterteilung: **10.05.2023**
(21) Anmeldenummer: 21194219.8
(22) Anmeldetag: 01.09.2021
(51) Int. Cl.: H05K 7/02

(54) **FUNKTIONSMODUL FÜR EIN MODULARES SYSTEM UND MODULARES SYSTEM**
FUNCTIONAL MODULE FOR A MODULAR SYSTEM AND MODULAR SYSTEM
MODULE FONCTIONNEL POUR UN SYSTÈME MODULAIRE ET SYSTÈME MODULAIRE

(30) Priorität: 02.09.2020 DE 102020122899
(43) Veröffentlichungstag der Anmeldung: 09.03.2022
(73) Patentinhaber: Leo Cases GmbH, 53332 Bornheim (DE); VINCORION Power Systems GmbH, 86972 Altenstadt (DE)
(72) Erfinder: Hadersbeck, Franz, 86972 Schwabniederhofen (DE); Scheller, Alexander, 53332 Bornheim (DE); Eurich, Wilhelm, 53332 Bornheim (DE)
(74) Vertreter: Aurigium Leischner & Luthe

(56) Entgegenhaltungen:
- DE-A1-102015 205 518
- US-A1- 2013 279 121
- US-A1- 2014 308 830
- US-B1- 6 522 550

## Beschreibung

Die Erfindung betrifft ein Funktionsmodul für ein modulares System und ein modulares System, insbesondere ein portables, modulares System zum mobilen Einsatz.

Das Dokument US 2013/279121 offenbart eine elektronische Vorrichtung-Baugruppenstruktur, die mit modularen Elektronikvorrichtungen und elektrischen Verbindungsmodulen ausgestattet ist.

Das Dokument DE 10 2015 205518 offenbart ein Elektronikgehäuse mit ein- und ausfahrbarem elektrischen Steckverbinder

Das Dokument US 6 522 550 offenbart elektronische Vorrichtungen zum Verbinden verschiedener Schnittstelleneinrichtungen des Typs USB.

Das Dokument US 2014/308830 offenbart ein elektronisches Gerät mit einem beweglichen Verbinder und einer Abdeckung zum Schutz des Verbinders, wobei ein externes Betätigungselement so ausgelegt ist, dass es die Abdeckung über einen Übertragungsabschnitt verschiebt und den Verbinder von einer eingezogenen Position in eine ausgefahrene Position bewegt.

Bei modularen Systemen kann eine Übertragung verschiedener Medien, wie beispielsweise Daten, Strom, Fluide und dergleichen, zwischen zwei Modulen insbesondere über eine einzige Schnittstelle zweier Gehäuse über ein außen anzubringendes Kabel erfolgen.

Vor diesem Hintergrund werden mit dem hier vorgestellten Ansatz ein Funktionsmodul für ein modulares System und ein modulares System gemäß den Hauptansprüchen vorgestellt. Vorteilhafte Ausgestaltungen und Weiterbildungen der Erfindung ergeben sich aus den nachfolgenden Unteransprüchen.

Gemäß Ausführungsformen kann insbesondere ein geführtes Steckerkupplungssystem im Schutzgrad IP54 zur Übertragung elektrischer, optischer, fluider und pneumatischer Medien zweier aufeinanderliegender oder nebeneinanderliegender Funktionsmodule für ein modulares System bereitgestellt werden. Zur Übertragung von beispielsweise Daten, Strom oder Fluiden zweier oder mehrerer Funktionsmodul untereinander kann eine Verdrahtung bzw. Verschlauchung bereitgestellt werden, welche im Betriebszustand insbesondere an der Anschlussstelle zum Gehäuse hin den Schutzgrad IP54 erfüllen kann. Insbesondere kann eine umweltdichte und kabellose Verbindung zur Übertragung von elektrischer Leistung, Fluiden und/oder von Informationen zwischen zwei oder mehreren Funktionsmodulen und der elektrischen Versorgung der eingesetzten Komponenten realisiert werden.

Vorteilhafterweise können gemäß Ausführungsformen insbesondere eine Zeitersparnis beim Aufbau, eine Reduzierung von Logistikaufwand durch Wegfall von Zubehörkabeln und eine sichere Verbindung durch mögliches Verhindern einer Trennung durch unbefugtes Personal erreicht werden. Es kann ein sicheres Zusammenführen zweier Stecker bzw. Schnittstelleneinheiten durch einen robusten Kuppelmechanismus realisiert werden, wobei der Schutzgrad sowohl im gekuppelten Zustand als auch im entkuppelten Zustand bzw. im Transportzustand den Schutzgrad IP54 aufweisen kann. Somit kann ein durchgehender IP54-Schutz einer Steckerkupplung bzw. von Schnittstellen von Funktionsmodulen für ein modulares System bereitgestellt werden, sodass ein Aufbau des Systems auch unter widrigen Bedingungen ermöglicht werden kann.

Es wird ein Funktionsmodul für ein modulares System vorgestellt, wobei das System zumindest zwei Funktionsmodule aufweist, die aufeinander und/oder nebeneinander gestapelt anordenbar oder angeordnet sind, wobei das Funktionsmodul folgende Merkmale aufweist:
ein Gehäuse mit zumindest einer Schnittstellenöffnung;
zumindest eine Schnittstelleneinheit, wobei die zumindest eine Schnittstelleneinheit in dem Gehäuse benachbart zu der zumindest einen Schnittstellenöffnung angeordnet ist, wobei die zumindest eine Schnittstelleneinheit elektrisch, optisch, fluidisch und/oder informationstechnisch mit zumindest einer in dem Gehäuse angeordneten Funktionseinheit verbunden ist, wobei die zumindest eine Schnittstelleneinheit ausgeformt ist, um mit einer weiteren Schnittstelleneinheit eines weiteren Funktionsmoduls des Systems koppelbar zu sein, um eine elektrische, optische, fluidische und/oder informationstechnische Verbindung zu der weiteren Schnittstelleneinheit herzustellen;
zumindest einen Schutzdeckel, der zwischen einer Verschlussstellung, in welcher die zumindest eine Schnittstellenöffnung des Gehäuses durch den zumindest einen Schutzdeckel verschlossen ist, und einer Öffnungsstellung, in welcher die zumindest eine Schnittstellenöffnung geöffnet ist, bewegbar angeordnet ist; und
eine Mechanikeinheit mit einem von außerhalb des Gehäuses zugreifbaren Betätigungselement und einem Übertragungsabschnitt, wobei die Mechanikeinheit ausgebildet ist, um eine Bewegung des Betätigungselements über den Übertragungsabschnitt auf zumindest ein Abtriebselement zu übertragen, wobei das zumindest eine Abtriebselement mindestens den zumindest einen Schutzdeckel umfasst, wobei die Mechanikeinheit ausgebildet ist, um eine Bewegung des Betätigungselements über den Übertragungsabschnitt auf den zumindest einen Schutzdeckel zu übertragen, um den zumindest einen Schutzdeckel zwischen der Verschlussstellung und der Öffnungsstellung zu bewegen.

Das modulare System kann für einen mobilen Einsatz vorgesehen sein. Dabei kann ein Standort, Betriebsort oder Einsatzort des modularen Systems verlagert werden. Es können unterschiedliche Funktionsmodule für verschiedene Funktionen vorgesehen sein. Die Anzahl der Funktionsmodule kann für einen Einsatz des modularen Systems abhängig von Einsatzbedingungen variiert werden oder variabel festgelegt werden. Auch kann Art oder Typ der Funktionsmodule für einen Einsatz des modularen Systems abhängig von Einsatzbedingungen variiert werden oder variabel festgelegt werden. Bei dem Funktionsmodul kann es sich beispielsweise um einen sogenannten Betriebs-, Transport und Lagerbehälter handeln. Das Gehäuse kann einteilig oder mehrteilig ausgeführt sein. Die zumindest eine Schnittstellenöffnung kann als eine Durchgangsöffnung in dem Gehäuse ausgeformt sein. Die elektrische, optische, fluidische und/oder informationstechnische Verbindung kann eine elektrische und/oder optische und/oder fluidische und/oder informationstechnische Verbindung sein. Die zumindest eine Schnittstelleneinheit kann in einem entkoppelten Zustand des Funktionsmoduls, in dem das Funktionsmodul nicht mit zumindest einem weiteren Funktionsmodul gestapelt ist, innerhalb des Gehäuses angeordnet sein, und kann in einem gekoppelten Zustand des Funktionsmoduls, in dem das Funktionsmodul mit zumindest einem weiteren Funktionsmodul gestapelt ist, innerhalb des Gehäuses angeordnet sein oder zumindest teilweise außerhalb des Gehäuses angeordnet sein. Der Übertragungsabschnitt kann auch als ein Getriebe, als eine Steuerung oder als eine Kurvensteuerung bezeichnet werden.

Gemäß einer Ausführungsform kann die Mechanikeinheit ausgebildet sein, um eine Drehbewegung des Betätigungselements über den Übertragungsabschnitt in eine translatorische Bewegung des zumindest einen Abtriebselements umzusetzen. Eine solche Ausführungsform bietet den Vorteil, dass eine einfache und platzsparende Art der Betätigung durch Drehen des Betätigungselements in eine Verschiebung umgesetzt werden kann.

Insbesondere kann der Übertragungsabschnitt der Mechanikeinheit als ein Kurvengetriebe mit zumindest einer Kurvenscheibe oder Kulissenscheibe mit einer eine Steuerkurve aufweisenden Nut zum Führen eines Führungsstiftes der Mechanikeinheit ausgeführt sein. Eine solche Ausführungsform bietet den Vorteil, dass je nach gewünschter Anwendung vielfältige und/oder komplizierte Bewegungsabläufe des zumindest einen Abtriebselements mit wenig Aufwand realisiert werden können.

Auch kann die Mechanikeinheit zumindest ein Führungselement zum Führen des zumindest einen Abtriebselements entlang zumindest einer Bewegungsachse aufweisen. Zusätzlich oder alternativ kann die Mechanikeinheit ein Gestänge aufweisen, das mit dem Übertragungsabschnitt und mit dem zumindest einen Abtriebselement gekoppelt ist. Das Gestänge kann zumindest einen Führungsstift zum Eingriff in die eine Steuerkurve aufweisende Nut der zumindest einen Kurvenscheibe oder Kulissenscheibe des Kurvengetriebes aufweisen. Eine solche Ausführungsform bietet den Vorteil, dass eine zuverlässige Führung des zumindest einen Abtriebselements bei Betätigung eines einzigen Betätigungselements erreicht werden kann. Insbesondere kann ein vertikal und/oder horizontal geführtes Kupplungssystem für Funktionsmodule über eine Kurvensteuerung bereitgestellt werden.

Gemäß einer Ausführungsform kann das zumindest eine Abtriebselement die zumindest eine Schnittstelleneinheit umfassen, wobei die Schnittstelleneinheit zwischen einer eingefahrenen Stellung, in der die zumindest eine Schnittstelleneinheit in das Gehäuse eingefahren ist, und einer ausgefahrenen Stellung, in der die zumindest eine Schnittstelleneinheit durch die zumindest eine Schnittstellenöffnung hindurch zumindest teilweise aus dem Gehäuse ausgefahren ist, bewegbar angeordnet sein kann. Hierbei kann die Mechanikeinheit ausgebildet sein, um eine Bewegung des Betätigungselements über den Übertragungsabschnitt auf die zumindest eine Schnittstelleneinheit zu übertragen, um die zumindest eine Schnittstelleneinheit zwischen der eingefahrenen Stellung und der ausgefahrenen Stellung zu bewegen. Wenn das Funktionsmodul beispielsweise zwei Schnittstelleneinheiten aufweist, kann das zumindest eine Abtriebselement insbesondere eine der Schnittstelleneinheiten umfassen. Eine solche Ausführungsform bietet den Vorteil, dass eine Übertragung beispielsweise elektrischer, optischer, fluider und pneumatischer Medien zwischen zwei oder mehreren Funktionsmodulen ohne zusätzliche Verbindungskabel oder Schläuche erreicht werden kann. Es kann ein Öffnen und Schließen von vorgesehenen Öffnungen zweier aufeinanderliegender oder nebeneinanderliegender Gehäuse von Funktionsmodulen mit anschließendem Zusammenführen zweier Stecker bzw. Schnittstelleneinheiten und anschließendem Verschließen der Öffnungen bei zusammengestecktem Steckerpärchen insbesondere mit dem Schutzgrad IP54 erreicht werden. Verbindungskabel und/oder Verbindungsschläuche brauchen nicht mitgeführt zu werden und ein Herstellen von Verbindungen kann zeitsparend erfolgen, wobei zum Beispiel Kabelschlaufen im Betrieb vermieden werden können.

Auch kann das Funktionsmodul eine Mehrzahl von Füßen an einer Standflächenseite des Gehäuses und eine Mehrzahl von Aufnahmeabschnitten an einer von der Standflächenseite abgewandten Oberseite des Gehäuses zum partiellen Aufnehmen weiterer Füße eines weiteren Funktionsmoduls des Systems aufweisen. Hierbei kann das zumindest eine Abtriebselement die Aufnahmeabschnitte umfassen, wobei die Aufnahmeabschnitte zwischen einer entriegelten Stellung, in der die weiteren Füße relativ zu den Aufnahmeabschnitten bewegbar sind, und einer verriegelten Stellung, in der die weiteren Füße in den Aufnahmeabschnitten verriegelt sind, bewegbar angeordnet sein können. Hierbei kann die Mechanikeinheit ausgebildet sein, um eine Bewegung des Betätigungselements über den Übertragungsabschnitt auf die Aufnahmeabschnitte zu übertragen, um die Aufnahmeabschnitte zwischen der entriegelten Stellung und der verriegelten Stellung zu bewegen. Eine solche Ausführungsform bietet den Vorteil, dass eine robuste und zuverlässige Kopplung von Funktionsmodulen zum Aufbau des Systems realisiert werden kann. Die Kopplung kann insbesondere in Gestalt eines gefederten Bajonettverschlusses ausgeführt sein.

Ferner kann das Funktionsmodul zumindest ein Klemmelement zum Festklemmen des zumindest einen Schutzdeckels gegen das Gehäuse in der Verschlussstellung umfassen. Hierbei kann das zumindest eine Klemmelement zwischen einer Klemmstellung, in der das zumindest eine Klemmelement in Anlage gegen den zumindest einen Schutzdeckel angeordnet ist, und einer Freigabestellung, in der das zumindest eine Klemmelement von dem zumindest einen Schutzdeckel beabstandet angeordnet ist, bewegbar angeordnet sein. Dabei kann die Mechanikeinheit ausgebildet sein, um eine Bewegung des Betätigungselements über den Übertragungsabschnitt auf das zumindest eine Klemmelement zu übertragen, um das zumindest eine Klemmelement zwischen der Klemmstellung und der Freigabestellung zu bewegen. Eine solche Ausführungsform bietet den Vorteil, dass eine abdichtende Schutzwirkung des zumindest einen Schutzdeckels noch verstärkt bzw. weiter erhöht werden kann.

Gemäß einer Ausführungsform kann das Funktionsmodul zumindest ein erstes Abtriebselement und zumindest ein zweites Abtriebselement aufweisen. Hierbei kann das zumindest eine erste Abtriebselement im Bereich einer ersten Hauptoberfläche des Gehäuses angeordnet sein, an der ein weiteres Funktionsmodul des Systems auf dem Funktionsmodul gestapelt anordenbar oder angeordnet ist. Dabei kann das zumindest eine zweite Abtriebselement im Bereich einer von der ersten Hauptoberfläche abgewandten zweiten Hauptoberfläche des Gehäuses angeordnet sein, an der das Funktionsmodul auf einem weiteren Funktionsmodul des Systems gestapelt anordenbar oder angeordnet ist. Das zumindest eine erste Abtriebselement kann einen Schutzdeckel, eine Schnittstelleneinheit und die Aufnahmeabschnitte sowie optional ein Klemmelement umfassen. Das zumindest eine zweite Abtriebselementen kann einen Schutzdeckel sowie optional ein Klemmelement umfassen. Eine solche Ausführungsform bietet den Vorteil, dass je nach Anordnung des Funktionsmoduls relativ zu mindestens einem weiteren Funktionsmodul des modularen Systems eine abgedichtete, zuverlässige und zumindest teilweise automatisierte Kopplung und Verbindung der Funktionsmodule erreicht werden kann.

Dabei kann das Funktionsmodul eine Kupplungseinheit umfassen, die mechanisch zwischen das Betätigungselement und den Übertragungsabschnitt der Mechanikeinheit geschaltet ist. Die Kupplungseinheit kann ausgebildet sein, um das Betätigungselement und den Übertragungsabschnitt abhängig davon, ob auf dem Funktionsmodul ein weiteres Funktionsmodul des Systems gestapelt angeordnet ist, und zusätzlich oder alternativ abhängig davon, ob das Funktionsmodul auf einem weiteren Funktionsmodul des Systems gestapelt angeordnet ist, miteinander zu koppeln, um die Bewegung des Betätigungselements auf das zumindest eine erste Abtriebselement und zusätzlich oder alternativ auf das zumindest eine zweite Abtriebselement zu übertragen. Eine solche Ausführungsform bietet den Vorteil, dass bei einer Betätigung des Betätigungselements lediglich die Abtriebselemente bewegt werden, die auch tatsächlich benötigt werden, je nachdem, ob auf und/oder unter dem Funktionsmodul ein weiteres Funktionsmodul gestapelt ist.

Auch kann dabei die Kupplungseinheit einen ersten Druckbolzen, der durch ein auf dem Funktionsmodul gestapelt angeordnetes weiteres Funktionsmodul des Systems verschiebbar ist, um die Kupplungseinheit zu betätigen, und einen zweiten Druckbolzen aufweisen, der durch ein weiteres Funktionsmodul des Systems, auf dem das Funktionsmodul gestapelt ist, verschiebbar ist, um die Kupplungseinheit zu betätigen. Der erste Druckbolzen kann durch ein auf dem Funktionsmodul gestapeltes weiteres Funktionsmodul verschiebbar sein. Der zweite Druckbolzen kann durch ein unter dem Funktionsmodul gestapeltes weiteres Funktionsmodul verschiebbar sein. Eine solche Ausführungsform bietet den Vorteil, dass einfach und sicher erkannt werden kann, wie ein Stapelzustand des Funktionsmoduls in dem modularen System ist, und somit stets die für den Stapelzustand korrekten Abtriebselemente bewegt werden können.

Ferner kann das Funktionsmodul zumindest ein Dichtungselement aufweisen, das im Bereich der zumindest einen Schnittstellenöffnung an dem Gehäuse und zusätzlich oder alternativ an dem Schutzdeckel angeordnet ist. Hierbei kann das zumindest eine Dichtungselement als eine Schleusendichtung, als eine Lamellendichtung und zusätzlich oder alternativ als eine EMV-Dichtung ausgeführt sein. Eine EMV-Dichtung kann ausgebildet sein, um eine Abschirmung vor elektrischen und/oder elektromagnetischen Störungen zu bewirken. Das zumindest eine Dichtungselement kann mit zumindest einem weiteren Dichtungselement eines weiteren Funktionsmoduls des Systems in einem gestapelten Zustand des Funktionsmoduls und des weiteren Funktionsmoduls zusammenwirken, um einen Gehäuseinnenraum gegenüber der Umwelt abzudichten. Eine solche Ausführungsform bietet den Vorteil, dass ein hoher Schutzgrad ermöglicht werden kann.

Es wird auch ein modulares System vorgestellt, wobei das modulare System zumindest zwei Funktionsmodule aufweist, die aufeinander und/oder nebeneinander gestapelt anordenbar oder angeordnet sind, wobei jedes der Funktionsmodule eine Ausführungsform des vorstehend genannten Funktionsmoduls ist.

Somit kann eine Mehrzahl von vorstehend beschriebenen Funktionsmodulen aufeinander und/oder nebeneinander gestapelt und zumindest über die Schnittstelleneinheiten miteinander gekoppelt sein, um das modulare System zu bilden.

Gemäß einer Ausführungsform können die Schnittstelleneinheiten der Funktionsmodule eine einheitliche Bauform aufweisen. Jede Schnittstelleneinheit jedes Funktionsmoduls kann mit einer Schnittstelleneinheit jedes anderen Funktionsmoduls koppelbar oder verbindbar sein. Eine einheitliche Ausführung der Schnittstelleneinheiten kann eine einheitliche geometrische Ausformung und zusätzlich oder alternativ eine einheitliche Art, Anzahl und zusätzlich oder alternativ Position von Anschlüssen betreffen. Eine solche Ausführungsform bietet den Vorteil, dass Funktionsmodule, die mit von Funktionsmodul zu Funktionsmodul unterschiedlichen Funktionseinheiten bestückt sein können, einfach, zuverlässig und sicher über die Schnittstelleneinheiten verbunden sein können.

Auch können die Funktionsmodule eine einheitliche Bauform mit einer einheitlichen Grundfläche und zusätzlich oder alternativ mit zumindest einer einheitlichen Abmessung aufweisen. Die Grundfläche eines Funktionsmoduls kann eine Standfläche des Funktionsmoduls repräsentieren. Eine solche Ausführungsform bietet den Vorteil, dass ein logistischer Versorgungsaufwand und beispielsweise ein Kraftstoffverbrauch reduziert werden können, da die Funktionsmodule gleicher Bauform einfach und sicher gestapelt werden können.

Ein Ausführungsbeispiel der Erfindung ist in den Zeichnungen rein schematisch dargestellt und wird nachfolgend näher beschrieben. Es zeigt
- Fig. 1: ein modulares System gemäß einem Ausführungsbeispiel;
- Fig. 2: ein Funktionsmodul gemäß einem Ausführungsbeispiel;
- Fig. 3: ein modulares System gemäß einem Ausführungsbeispiel;
- Fig. 4: ein Ausführungsbeispiel eines Übertragungsabschnitts eines Funktionsmoduls;
- Fig. 5: ein Ausführungsbeispiel einer Kurvenscheibe eines Übertragungsabschnitts eines Funktionsmoduls;
- Fig. 6: ein Funktionsmodul gemäß einem Ausführungsbeispiel;
- Fig. 7: das Funktionsmodul aus Fig. 6 ohne Gehäuse;
- Fig. 8: einen Teilabschnitt des Funktionsmoduls aus Fig. 6 bzw. Fig. 7;
- Fig. 9: einen Teilabschnitt des Funktionsmoduls aus Fig. 6 bzw. Fig. 7;
- Fig. 10: ein modulares System gemäß einem Ausführungsbeispiel;
- Fig. 11: einen Teilabschnitt des modularen Systems aus Fig. 10;
- Fig. 12: einen Teilabschnitt der Kupplungseinheit des in Fig. 11 unten dargestellten Funktionsmoduls;
- Fig. 13: einen Teilabschnitt des modularen Systems aus Fig. 10;
- Fig. 14: einen Teilabschnitt des modularen Systems aus Fig. 10;
- Fig. 15: das in Fig. 10 unten dargestellte Funktionsmodul ohne Gehäuse; und
- Fig. 16: einen Teilabschnitt des Funktionsmoduls aus Fig. 15.

In der nachfolgenden Beschreibung günstiger Ausführungsbeispiele der vorliegenden Erfindung werden für die in den verschiedenen Figuren dargestellten und ähnlich wirkenden Elemente gleiche oder ähnliche Bezugszeichen verwendet, wobei auf eine wiederholte Beschreibung dieser Elemente verzichtet wird.

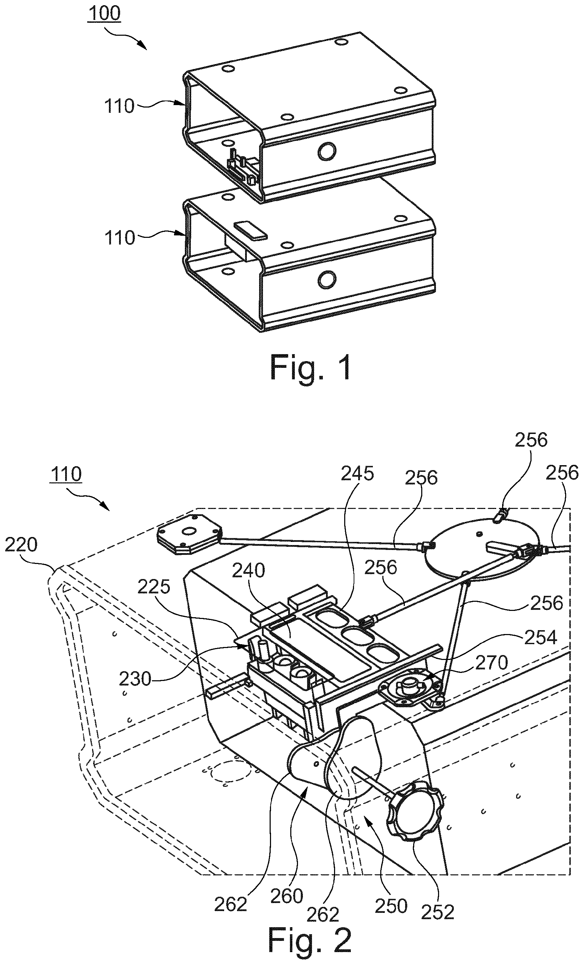

Fig. 1 zeigt ein modulares System 100. Das modulare System 100 ist für einen mobilen Einsatz vorgesehen, insbesondere für einen Einsatz abseits von einer versorgungstechnischen Infrastruktur. Das modulare System 100 umfasst zumindest zwei Funktionsmodule 110. Bei den Funktionsmodulen 110 handelt es sich beispielsweise um sogenannte Betriebs-, Transport und Lagerbehälter, insbesondere für zivilen oder militärischen Einsatz. Die Funktionsmodule 110 sind aufeinander und/oder nebeneinander gestapelt anordenbar. In der Darstellung von Fig. 1 sind die Funktionsmodule 110 übereinander angeordnet und voneinander beanstandet, beispielsweise im Verlauf eines Stapelvorgangs. Am Ende des Stapelvorgangs sind die Funktionsmodule 110 aufeinander gestapelt angeordnet.

Die Funktionsmodule 110 sind ausgebildet, um zumindest eine Funktion bereitzustellen. Dabei sind die Funktionsmodule 110 hinsichtlich der zumindest einen Funktion identisch oder voneinander verschieden. Gemäß einem Ausführungsbeispiel umfasst das modulare System 100 eine Mehrzahl oder Vielzahl von Funktionsmodulen 110, beispielsweise drei oder mehr Funktionsmodule 110. Gemäß dem hier dargestellten Ausführungsbeispiel weisen Funktionsmodule 110 eine einheitliche Bauform mit einer einheitlichen Grundfläche und/oder zumindest einer einheitlichen Abmessung auf.

Ein Funktionsmodul 110 wie eines der hier dargestellten beispielhaft zwei Funktionsmodule 110 ist nachstehend unter Bezugnahme auf nachfolgende Figuren noch detaillierter erläutert.

Fig. 2 zeigt ein Funktionsmodul 110 gemäß einem Ausführungsbeispiel. Von dem Funktionsmodul 110 ist in der Darstellung von Fig. 2 ein Teilabschnitt gezeigt. Das Funktionsmodul 110 entspricht oder ähnelt hierbei einem der Funktionsmodule 110 aus Fig. 1. Das Funktionsmodul 110 umfasst ein Gehäuse ein Gehäuse 220 mit zumindest einer Schnittstellenöffnung 225, zumindest eine Schnittstelleneinheit 230, hier beispielhaft lediglich eine Schnittstelleneinheit 230, zumindest einen Schutzdeckel 240, hier beispielhaft lediglich einen Schutzdeckel 240, und eine Mechanikeinheit 250.

Die Schnittstellenöffnung 225 ist in dem Gehäuse 220 ausgeformt. Dabei ist die Schnittstellenöffnung 225 als eine Durchgangsöffnung durch eine Wand des Gehäuses 220 hindurch ausgeführt. Die Schnittstelleneinheit 230 ist in dem Gehäuse 220 benachbart zu der Schnittstellenöffnung 225 angeordnet. Die Schnittstelleneinheit 230 ist durch die Schnittstellenöffnung 225 hindurch von außen zugreifbar. Die Schnittstelleneinheit 230 ist 245 elektrisch, optisch, fluidisch und/oder informationstechnisch mit zumindest einer in dem Gehäuse 220 angeordneten Funktionseinheit (nicht gezeigt) verbunden. Die Schnittstelleneinheit 230 ist ausgeformt, um mit einer weiteren Schnittstelleneinheit eines weiteren Funktionsmoduls des modularen Systems koppelbar zu sein, um eine elektrische, optische, fluidische und/oder informationstechnische Verbindung zu der weiteren Schnittstelleneinheit herzustellen. Bezogen auf das modulare System, für welches das Funktionsmodul 110 vorgesehen ist, weisen alle Schnittstelleneinheiten aller Funktionsmodule des Systems und somit auch die Schnittstelleneinheit 230 eine einheitliche Bauform auf. Anders ausgedrückt ist insbesondere eine Konfiguration der Schnittstelleneinheit 230 standardisiert und für alle weiteren Schnittstelleneinheit weiterer Funktionsmodule des Systems identisch.

Der Schutzdeckel 240 ist in dem Gehäuse 220 benachbart zu der Schnittstellenöffnung 225 angeordnet. Dabei ist der Schutzdeckel 240 zwischen einer Verschlussstellung, in welcher die Schnittstellenöffnung 225 durch den Schutzdeckel 240 verschlossen ist, und einer Öffnungsstellung, in welcher die Schnittstellenöffnung 225 geöffnet ist, bewegbar angeordnet. Somit ist der Schutzdeckel 240 bewegbar, insbesondere verschiebbar, um die Schnittstellenöffnung 225 wahlweise zu verschließen oder zu öffnen.

Die Mechanikeinheit 250 umfasst ein Betätigungselement 252 und einen Übertragungsabschnitt 260. Das Betätigungselement 252 ist von außerhalb des Gehäuses 220 zugreifbar. Gemäß dem hier dargestellten Ausführungsbeispiel ist das Betätigungselement 252 als ein Drehrad, Drehhebel oder dergleichen ausgeformt. Das Betätigungselement 252 ist durch einen Benutzer des Funktionsmoduls 110 betätigbar. Die Mechanikeinheit 250 ist ausgebildet, um eine Bewegung des Betätigungselements 252 über den Übertragungsabschnitt 260 auf zumindest ein Abtriebselement zu übertragen. Das zumindest eine Abtriebselement umfasst hierbei mindestens den Schutzdeckel 240. Somit ist die Mechanikeinheit 250 ausgebildet, um eine Bewegung des Betätigungselements 252 über den Übertragungsabschnitt 260 auf den Schutzdeckel 240 zu übertragen, um den Schutzdeckel 240 zwischen der Verschlussstellung und der Öffnungsstellung zu bewegen.

Gemäß dem hier dargestellten Ausführungsbeispiel weist das Funktionsmodul 110 auch zumindest ein Klemmelement 245, hier beispielhaft lediglich ein Klemmelement 245 auf. Das Klemmelement 245 ist ausgebildet, um den Schutzdeckel 240 in dessen Verschlussstellung gegen das Gehäuse 220 festzuklemmen. Dabei ist das Klemmelement 245 zwischen einer Klemmstellung, in der das Klemmelement 245 in Anlage gegen den Schutzdeckel 240 angeordnet ist, und einer Freigabestellung, in der das Klemmelement 245 von dem Schutzdeckel 240 beabstandet angeordnet ist, bewegbar angeordnet. Die Mechanikeinheit 250 ist ausgebildet, um eine Bewegung des Betätigungselements 252 über den Übertragungsabschnitt 260 auf das zumindest eine Klemmelement 245 zu übertragen, um das zumindest eine Klemmelement 245 zwischen der Klemmstellung und der Freigabestellung zu bewegen. Somit handelt es sich bei dem Klemmelement 245 hierbei auch um ein Abtriebselement.

Ferner umfasst das Funktionsmodul 110 gemäß dem hier dargestellten Ausführungsbeispiel eine Mehrzahl von Füßen, die darstellungsbedingt in Fig. 2 nicht gezeigt sind, an einer Standflächenseite des Gehäuses 220 und eine Mehrzahl von Aufnahmeabschnitten 270, beispielsweise vier Aufnahmeabschnitte 270, an einer von der Standflächenseite abgewandten Oberseite des Gehäuses 220 zum partiellen Aufnehmen weiterer Füße eines weiteren Funktionsmoduls des Systems. Darstellungsbedingt ist in Fig. 2 lediglich ein Aufnahmeabschnitt 270 gezeigt. Das Funktionsmodul 110 umfasst beispielsweise vier Aufnahmeabschnitte 270, einen in jeder Eckregion der Oberseite des Gehäuses 220. Jeder der Aufnahmeabschnitte 270 ist zwischen einer entriegelten Stellung, in der die weiteren Füße relativ zu den Aufnahmeabschnitten 270 bewegbar sind, und einer verriegelten Stellung, in der die weiteren Füße in den Aufnahmeabschnitten 270 verriegelt sind, bewegbar angeordnet. Es handelt sich bei den Aufnahmeabschnitten 270 auch um Abtriebselemente. Die Mechanikeinheit 250 ist ausgebildet, um eine Bewegung des Betätigungselements 252 über den Übertragungsabschnitt 260 auf die Aufnahmeabschnitte 270 zu übertragen, um die Aufnahmeabschnitte 270 zwischen der entriegelten Stellung und der verriegelten Stellung zu bewegen. Durch die Aufnahmeabschnitte 270 ist ein gefederter Bajonettverschluss zum Koppeln des Funktionsmoduls 110 mit mindestens einem weiteren Funktionsmodul realisiert.

Insbesondere ist auch die Schnittstelleneinheit 230 ein Abtriebselement. Dabei ist die Schnittstelleneinheit 230 zwischen einer eingefahrenen Stellung, in der die Schnittstelleneinheit 230 in das Gehäuse 220 eingefahren ist, was in Fig. 2 abgebildet ist, und einer ausgefahrenen Stellung, in der die Schnittstelleneinheit 230 durch die zumindest eine Schnittstellenöffnung 225 hindurch zumindest teilweise aus dem Gehäuse 220 ausgefahren ist, bewegbar angeordnet. Die Mechanikeinheit 250 ist ausgebildet, um eine Bewegung des Betätigungselements 252 über den Übertragungsabschnitt 260 auf die Schnittstelleneinheit 230 zu übertragen, um die Schnittstelleneinheit 230 zwischen der eingefahrenen Stellung und der ausgefahrenen Stellung zu bewegen.

Gemäß dem hier dargestellten Ausführungsbeispiel ist die Mechanikeinheit 250 ausgebildet, um eine Drehbewegung des Betätigungselements 252 über den Übertragungsabschnitt 260 in eine translatorische Bewegung des zumindest einen Abtriebselements umzusetzen. Auch ist gemäß dem hier dargestellten Ausführungsbeispiel der Übertragungsabschnitt 260 der Mechanikeinheit 250 als ein Kurvengetriebe mit zumindest einer Kurvenscheibe 262 oder Kulissenscheibe ausgeführt, hier lediglich beispielhaft zwei Kurvenscheiben 262. Ferner umfasst die Mechanikeinheit 250 gemäß dem hier dargestellten Ausführungsbeispiel zumindest ein Führungselement 254 zum Führen des zumindest einen Abtriebselements entlang zumindest einer Bewegungsachse. Hierbei ist das zumindest ein Führungselement 254 ausgebildet, um den Schutzdeckel 240, das Klemmelement 245 und die Schnittstelleneinheit 230 entlang jeweiliger Bewegungsachsen zu führen. Insbesondere werden hierbei der Schutzdeckel 240 und das Klemmelement 245 entlang einer gemeinsamen ersten Bewegungsachse geführt und wird die Schnittstelleneinheit 230 entlang einer zweiten Bewegungsachse geführt, die sich orthogonal oder quer zu der ersten Bewegungsachse erstreckt. Auch umfasst die Mechanikeinheit 250 gemäß dem hier dargestellten Ausführungsbeispiel ein Gestänge 256, das mit dem Übertragungsabschnitt 250 und mit dem zumindest einen Abtriebselement gekoppelt ist. Hierbei ist das Gestänge 256 mit dem Übertragungsabschnitt 250 einerseits und insbesondere mit dem Klemmelement 245 und mit den Aufnahmeabschnitten 270 gekoppelt.

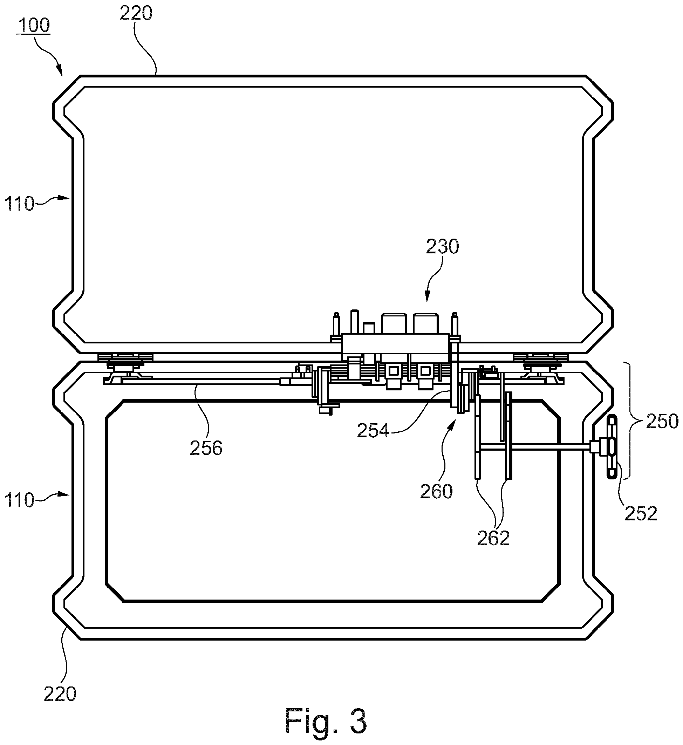

Fig. 3 zeigt ein modulares System 100 gemäß einem Ausführungsbeispiel. Dabei entspricht oder ähnelt das modulare System 100 dem modularen System aus Fig. 1. Das modulare System 100 umfasst lediglich beispielhaft zwei Funktionsmodule 110. Die Funktionsmodule 110 sind in der Darstellung von Fig. 3 aufeinandergestapelt angeordnet. Insbesondere entspricht oder ähnelt das in der Darstellung von Fig. 3 unten gezeigte Funktionsmodul 110 dem Funktionsmodul aus Fig. 2. Hierbei ist von dem in der Darstellung von Fig. 3 oben gezeigten Funktionsmodul 110 lediglich das Gehäuse 220 explizit gezeigt und bezeichnet und sind von dem in der Darstellung von Fig. 3 unten gezeigten Funktionsmodul 110 das Gehäuse 220, die Schnittstelleneinheit 230, die Mechanikeinheit 250, das Betätigungselement 252, das zumindest eine Führungselement 254, das Gestänge 256, der Übertragungsabschnitt 260 und zwei Kurvenscheiben 262 explizit gezeigt und bezeichnet. In der Darstellung von Fig. 3 ist die Schnittstelleneinheit 230 in der ausgefahrenen Stellung gezeigt. Hierbei ragt ein Teilabschnitt der Schnittstelleneinheit 230 in das Gehäuse 220 des in der Darstellung von Fig. 3 oben gezeigten Funktionsmoduls 110.

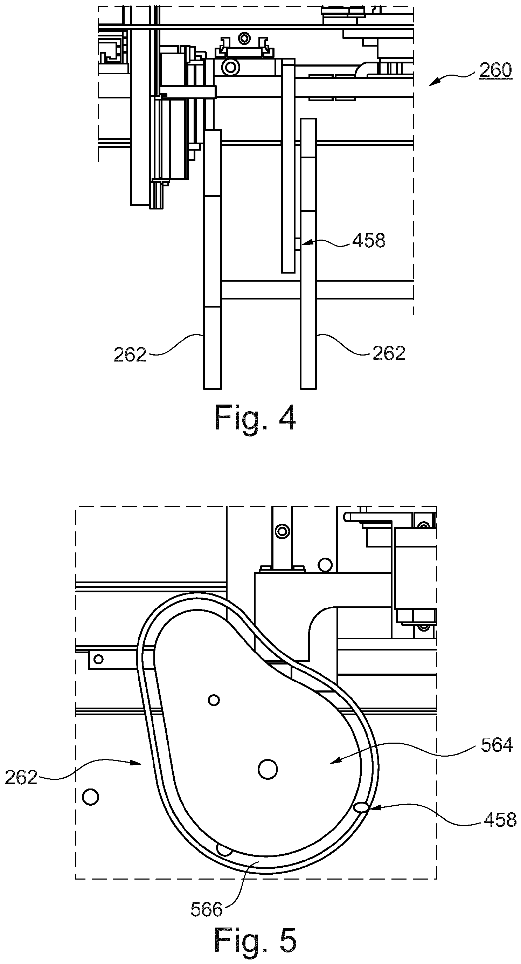

Fig. 4 zeigt ein Ausführungsbeispiel eines Übertragungsabschnitts 260 eines Funktionsmoduls. Der Übertragungsabschnitt 260 entspricht oder ähnelt dem Übertragungsabschnitt aus einer der vorstehend beschriebenen Figuren. Gezeigt sind zwei Kurvenscheiben 262, die auf einer gemeinsamen Welle montiert sind. Ferner ist Einführungsstift 456 gezeigt, der in eine Nut (in Fig. 4 nicht gezeigt) einer der Kurvenscheiben 262 eingreift. Der Führungsstift 458 ist an einem Element der Mechanikeinheit des Funktionsmoduls ausgeformt bzw. angeordnet.

Fig. 5 zeigt ein Ausführungsbeispiel einer Kurvenscheibe 262 eines Übertragungsabschnitts eines Funktionsmoduls. Die Kurvenscheibe 262 entspricht oder ähnelt einer der Kurvenscheiben aus einer der vorstehend beschriebenen Figuren. Die Kurvenscheibe 262 realisiert Steuerkurven 564. In der Kurvenscheibe 262 ist eine den Steuerkurven 564 folgende Nut 566 ausgeformt. In der Nut 566 ist der Führungsstift 458 führbar. In der Darstellung von Fig. 5 befindet sich der Führungsstift 458 aus Fig. 4 in Eingriff mit der Nut 566 der Kurvenscheibe 262.

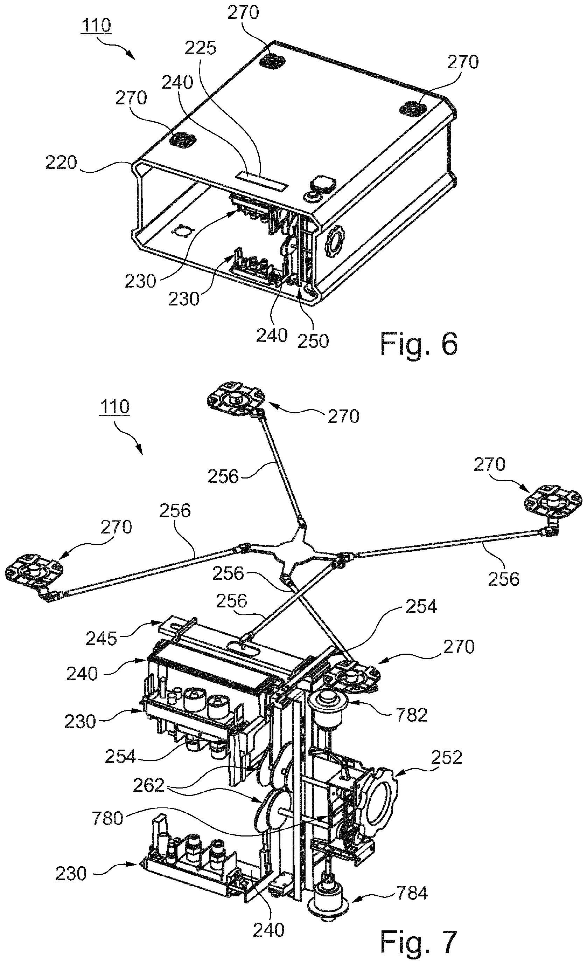

Fig. 6 zeigt ein Funktionsmodul 110 gemäß einem Ausführungsbeispiel. Das Funktionsmodul 110 ähnelt hierbei dem Funktionsmodul aus einer der vorstehend beschriebenen Figuren. Genauer gesagt entspricht das Funktionsmodul 110 dem Funktionsmodul aus einer der vorstehend beschriebenen Figuren mit Ausnahme dessen, dass das Funktionsmodul 110 zwei Schnittstellenöffnung 225, zwei Schnittstelleneinheiten 230 und zwei Schutzdeckel 240 umfasst. Von dem Funktionsmodul 110 sind in der Darstellung von Fig. 6 hierbei das Gehäuse 220, darstellungsbedingt lediglich eine der zwei Schnittstellenöffnungen 225, die zwei Schnittstelleneinheiten 230, die zwei Schutzdeckel 240, die Mechanikeinheit 250 und die Aufnahmeabschnitte 270 gezeigt. Ferner umfasst das Funktionsmodul 110 eine Kupplungseinheit, auf die unter Bezugnahme auf nachfolgende Figuren noch detaillierter eingegangen wird.

Gemäß dem in Fig. 6 dargestellten Ausführungsbeispiel umfasst das Funktionsmodul 110 zumindest ein erstes Abtriebselement und zumindest ein zweites Abtriebselement. Das zumindest eine erste Abtriebselement ist im Bereich einer ersten Hauptoberfläche des Gehäuses 220 angeordnet, an der ein weiteres Funktionsmodul des Systems auf dem Funktionsmodul 110 gestapelt anordenbar ist. An der ersten Hauptoberfläche des Gehäuses 220 sind auch die Aufnahmeabschnitte 270 angeordnet. Das zumindest eine zweite Abtriebselement ist im Bereich einer von der ersten Hauptoberfläche abgewandten zweiten Hauptoberfläche des Gehäuses 220 angeordnet, an der das Funktionsmodul 110 auf einem weiteren Funktionsmodul des Systems gestapelt anordenbar ist. Das zumindest eine erste Abtriebselement umfasst gemäß dem hier dargestellten Ausführungsbeispiel mindestens die Aufnahmeabschnitte 270, eine erste der Schnittstelleneinheit 230 und einen ersten der Schutzdeckel 240, optional zusätzlich ein Klemmelement. Das zumindest eine zweite Abtriebselement umfasst gemäß dem hier dargestellten Ausführungsbeispiel mindestens einen zweiten der Schutzdeckel 240, optional zusätzlich ein Klemmelement.

Fig. 7 zeigt das Funktionsmodul 110 aus Fig. 6 ohne Gehäuse. Dabei sind von dem Funktionsmodul 110 in der Darstellung von Fig. 7 die zwei Schnittstelleneinheiten 230, die zwei Schutzdeckel 240, ein Klemmelement 245, das Betätigungselement 252, Führungselemente 254, das Gestänge 256, Kurvenscheiben 262 bzw. Kulissenscheiben an zwei Wellen, vier Aufnahmeabschnitte 270, eine Kupplungseinheit 780, ein erster Druckbolzen 782 bzw. erster Druckknopf und ein zweiter Druckbolzen 784 bzw. zweiter Druckknopf gezeigt.

Hierbei sind an einer ersten Welle drei Kurvenscheiben 262 angeordnet und sind an einer zweiten Welle zwei Kurvenscheiben 262 angeordnet. Die drei Kurvenscheiben 262 an der ersten Welle dienen zum Übertragen der Bewegung des Betätigungselements 252 auf eine erste der Schnittstelleneinheiten 230, einen ersten der Schutzdeckel 240, das Klemmelement 245 und die Aufnahmeabschnitte 270. Die zwei Kurvenscheiben 262 an der zweiten Welle zum Übertragen der Bewegung des Betätigungselements 252 auf einen zweiten der Schutzdeckel 240. Es sind Führungselemente 254 zur horizontalen Führung, hier zum Führen der Schutzdeckel 240 und des Klemmelements 245, und Führungselemente 254 zur vertikalen Führung, hier zum Führen der ersten der Schnittstelleneinheiten 230 vorgesehen.

Die Kupplungseinheit 780 ist die mechanisch zwischen das Betätigungselement 252 und den Übertragungsabschnitt der Mechanikeinheit, genauer gesagt die Wellen mit den Kurvenscheiben 262, geschaltet. Die Kupplungseinheit 780 ist ausgebildet, um das Betätigungselement 252 und den Übertragungsabschnitt abhängig davon, ob auf dem Funktionsmodul 110 ein weiteres Funktionsmodul des Systems gestapelt angeordnet ist und/oder das Funktionsmodul 110 auf einem weiteren Funktionsmodul des Systems gestapelt angeordnet ist, miteinander zu koppeln, um die Bewegung des Betätigungselements 252 auf das zumindest eine erste Abtriebselement und/oder auf das zumindest eine zweite Abtriebselement zu übertragen. Die Kupplungseinheit 780 umfasst den ersten Druckbolzen 782 bzw. ersten Druckknopf, der durch ein auf dem Funktionsmodul 110 gestapelt angeordnetes weiteres Funktionsmodul des Systems verschiebbar ist, um die Kupplungseinheit 780 zu betätigen, und den zweiten Druckbolzen 784 bzw. zweiten Druckknopf, der durch ein weiteres Funktionsmodul des Systems, auf dem das Funktionsmodul 110 gestapelt ist, verschiebbar ist, um die Kupplungseinheit 780 zu betätigen.

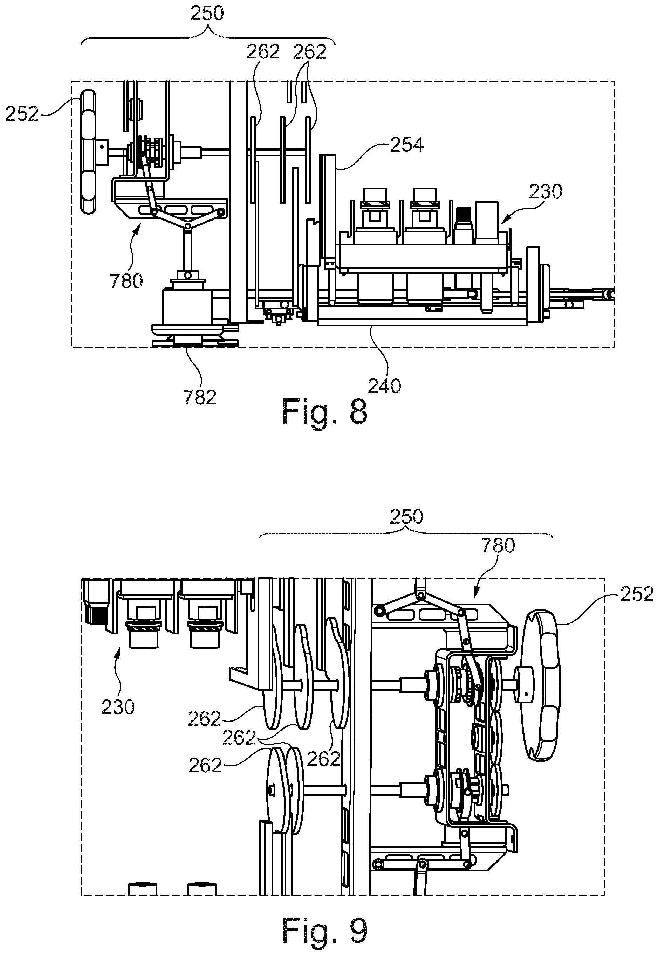

Fig. 8 zeigt einen Teilabschnitt des Funktionsmoduls aus Fig. 6 bzw. Fig. 7. In dem in Fig. 8 dargestellten Teilabschnitt sind von dem Funktionsmodul eine der Schnittstelleneinheiten 230, einer der Schutzdeckel 240, ein Teil der Mechanikeinheit 250, das Betätigungselement 252, ein Führungselement 254, die Welle mit den drei Kurvenscheiben 262, die Kupplungseinheit 780 und der erste Druckbolzen 782 gezeigt.

Fig. 9 zeigt einen Teilabschnitt des Funktionsmoduls aus Fig. 6 bzw. Fig. 7. In dem in Fig. 9 dargestellten Teilabschnitt sind von dem Funktionsmodul eine der Schnittstelleneinheiten 230, ein Teil der Mechanikeinheit 250, das Betätigungselement 252, die Wellen mit den insgesamt fünf Kurvenscheiben 262 und die Kupplungseinheit 780 gezeigt.

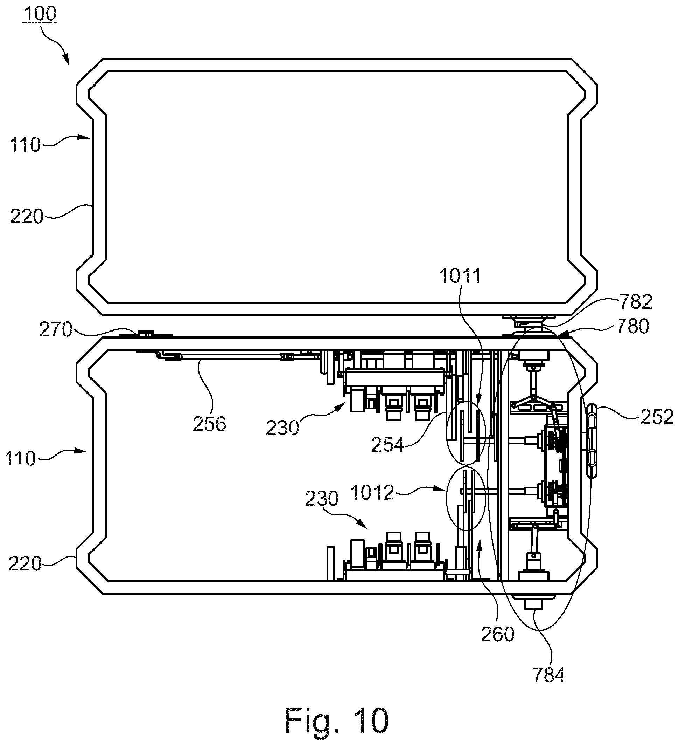

Fig. 10 zeigt ein modulares System 100 gemäß einem Ausführungsbeispiel. Das modulare System 100 entspricht oder ähnelt hierbei dem modularen System aus Fig. 1 bzw. ähnelt dem modularen System aus Fig. 3. Das modulare System 100 umfasst lediglich beispielhaft zwei Funktionsmodule 110. Die Funktionsmodule 110 sind in der Darstellung von Fig. 10 aufeinandergestapelt angeordnet. Insbesondere entspricht oder ähnelt das in der Darstellung von Fig. 10 unten gezeigte Funktionsmodul 110 dem Funktionsmodul aus Fig. 6 bzw. Fig. 7. Hierbei ist von dem in der Darstellung von Fig. 10 oben gezeigten Funktionsmodul 110 lediglich das Gehäuse 220 explizit gezeigt und bezeichnet und sind von dem in der Darstellung von Fig. 10 unten gezeigten Funktionsmodul 110 das Gehäuse 220, die Schnittstelleneinheiten 230, das Betätigungselement 252, das zumindest eine Führungselement 254, das Gestänge 256, der Übertragungsabschnitt 260, einer der Aufnahmeabschnitte 270, die Kupplungseinheit 780 mit dem ersten Druckbolzen 782 und dem zweiten Druckbolzen 784, einen ersten Steuerungsteil 1011 mit den drei Kurvenscheiben auf der ersten Welle zur Kurvensteuerung des zumindest einen ersten Abtriebselements und einen zweiten Steuerungsteil 1012 mit den zwei Kurvenscheiben auf der zweiten Welle zur Kurvensteuerung des zumindest einen zweiten Abtriebselements explizit gezeigt und bezeichnet.

In der Darstellung von Fig. 10 ist die oben dargestellte Schnittstelleneinheit 230 in der eingefahrenen Stellung gezeigt. Die Kupplungseinheit 780 fungiert als Sperrmechanismus, um das Betätigungselement 252 mit dem ersten Steuerungsteil 1011 und/oder mit dem zweiten Steuerungsteil 1012 zu koppeln und/oder dieselben von dem Betätigungselement 252 zu entkoppeln.

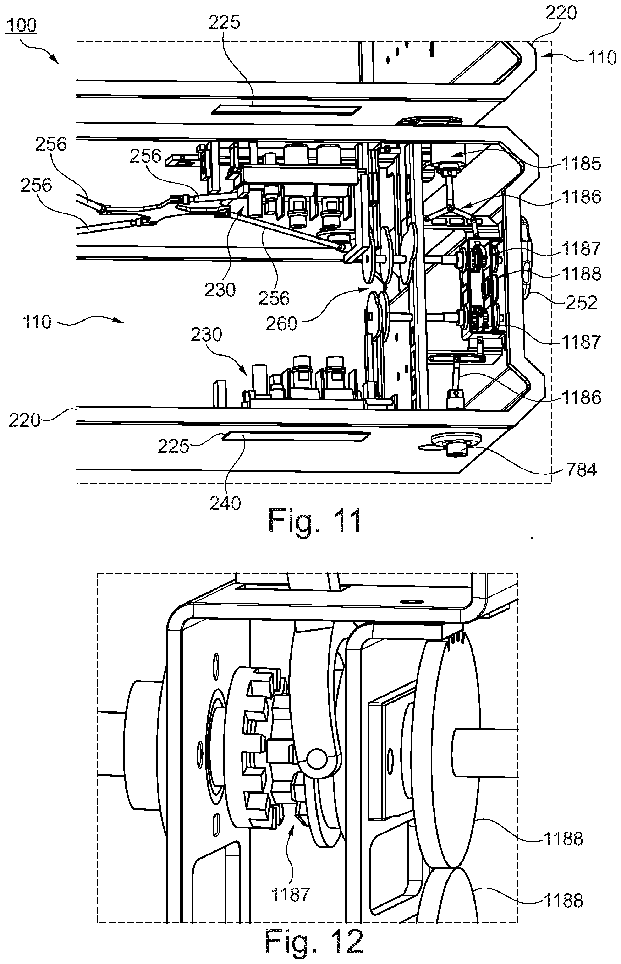

Fig. 11 zeigt einen Teilabschnitt des modularen Systems 100 aus Fig. 10. Hierbei sind von dem modularen System 100 das Gehäuse 220 mit einer Schnittstellenöffnung 225 des oben gezeigten Funktionsmoduls 110 dargestellt und sind von dem unten gezeigten Funktionsmodul 110 das Gehäuse 220, eine der Schnittstellenöffnungen 225, die beiden Schnittstelleneinheiten 230, einer der Schutzdeckel 240, das Betätigungselement 252, das Gestänge 256, der Übertragungsabschnitt 260 und von der Kupplungseinheit der zweite Druckbolzen 784, eine Führungsbuchse 1185, Hebel 1186, Kuppelstellen 1187 und Zahnräder 1188 dargestellt.

Die erste Welle des Übertragungsabschnitts 260, an der die beispielhaft drei Kurvenscheiben angeordnet sind, ist über eine erste der Kuppelstellen 1187 mit dem Betätigungselement 252 koppelbar. Die zweite Welle des Übertragungsabschnitts 260, der die beispielhaft zwei Kurvenscheiben angeordnet sind, ist über eine zweite der Kuppelstellen 1187 und die Zahnräder 1188 mit dem Betätigungselement 252 koppelbar. Der erste Druckbolzen, der hier darstellungsbedingt verdeckt ist, ist in der Führungsbuchse 1185 geführt und über einen der Hebel 1186 mit der ersten der Kuppelstellen 1187 verbunden. Der zweite Druckbolzen 784 ist in einer weiteren Führungsbuchse, die hier darstellungsbedingt verdeckt ist, geführt und über einen weiteren der Hebel 1186 mit der zweiten der Kuppelstellen 1187 verbunden. Wenn der erste Druckbolzen und/oder der zweite Druckbolzen 784 in Richtung eines Innenraums des Gehäuses 220 gedrückt ist bzw. sind, so wird an der Kuppelstelle 1187 oder den Kuppelstellen 1187 in einem eingekuppelten Zustand eine Drehmomentübertragung von dem Betätigungselement 252 auf die erste Welle und/oder die zweite Welle des Übertragungsabschnitts 260 ermöglicht. Wenn der erste Druckbolzen und/oder der zweite Druckbolzen 784 unbelastet ist bzw. sind, so wird an der Kuppelstelle 1187 oder den Kuppelstellen 1187 in einem ausgekuppelten Zustand eine Drehmomentübertragung von dem Betätigungselement 252 auf die erste Welle und/oder die zweite Welle des Übertragungsabschnitts 260 unterbrochen.

Fig. 12 zeigt einen Teilabschnitt der Kupplungseinheit des in Fig. 11 unten dargestellten Funktionsmoduls 110. Hierbei sind von der Kupplungseinheit zwei der Zahnräder 1188 und eine der Kupplungsstellen 1187 gezeigt und explizit bezeichnet. Die Kupplungsstelle 1187 ist hierbei in dem ausgekuppelten Zustand dargestellt.

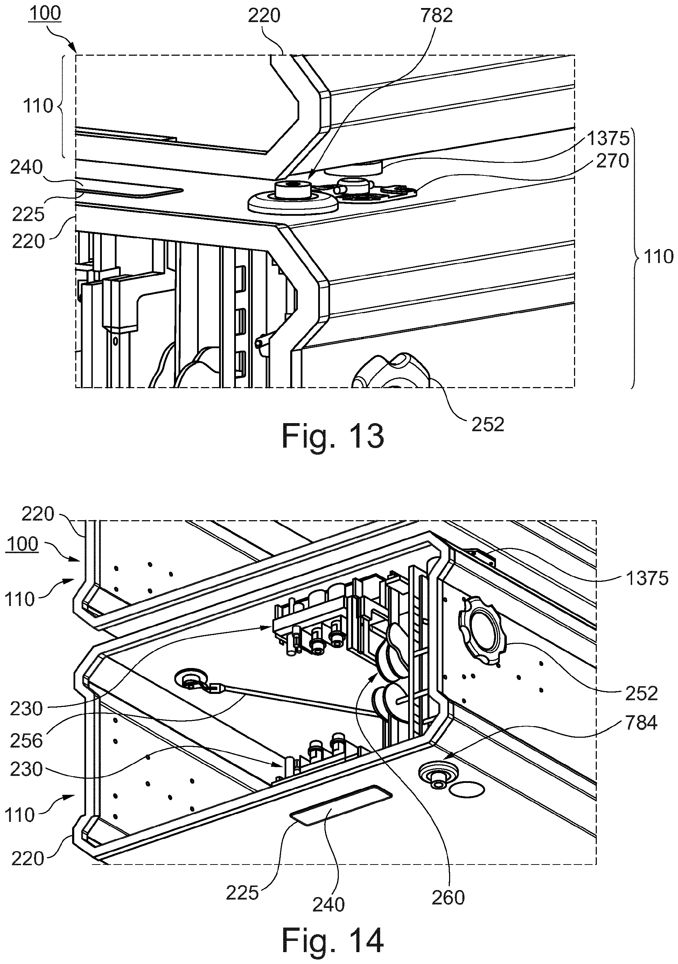

Fig. 13 zeigt einen Teilabschnitt des modularen Systems 100 aus Fig. 10. Hierbei sind von dem modularen System 100 das Gehäuse 220 und eines der Füße 1375 des oben gezeigten Funktionsmoduls 110 dargestellt und sind von dem unten gezeigten Funktionsmodul 110 das Gehäuse 220, eine der Schnittstellenöffnungen 225, einer der Schutzdeckel 240, das Betätigungselement 252, einer der Aufnahmeabschnitte 270 und der erste Druckbolzen 782 der Kupplungseinheit dargestellt. Die beiden Gehäuse 220 der Funktionsmodule 110 sind hierbei im Verlauf eines Stapelvorgangs bei einem bevorstehenden Kontakt zwischen dem Gehäuse 220 des oben gezeigten Funktionsmoduls 110 mit dem ersten Bolzen 782 der Kupplungseinheit des unten gezeigten Funktionsmoduls 110 sowie zwischen dem einen der Füße 1375 des oben gezeigten Funktionsmoduls 110 mit dem einen der Aufnahmeabschnitt 270 des unten gezeigten Funktionsmoduls 110 gezeigt.

Fig. 14 zeigt einen Teilabschnitt des modularen Systems 100 aus Fig. 10. Hierbei sind von dem modularen System 100 das Gehäuse 220 und eines der Füße 1375 des oben gezeigten Funktionsmoduls 110 dargestellt und sind von dem unten gezeigten Funktionsmodul 110 das Gehäuse 220, eine der Schnittstellenöffnungen 225, die Schnittstelleneinheiten 230, einer der Schutzdeckel 240, das Betätigungselement 252, ein Teil des Gestänges 256, der zweite Druckbolzen 784 der Kupplungseinheit und der Übertragungsabschnitt 260 dargestellt.

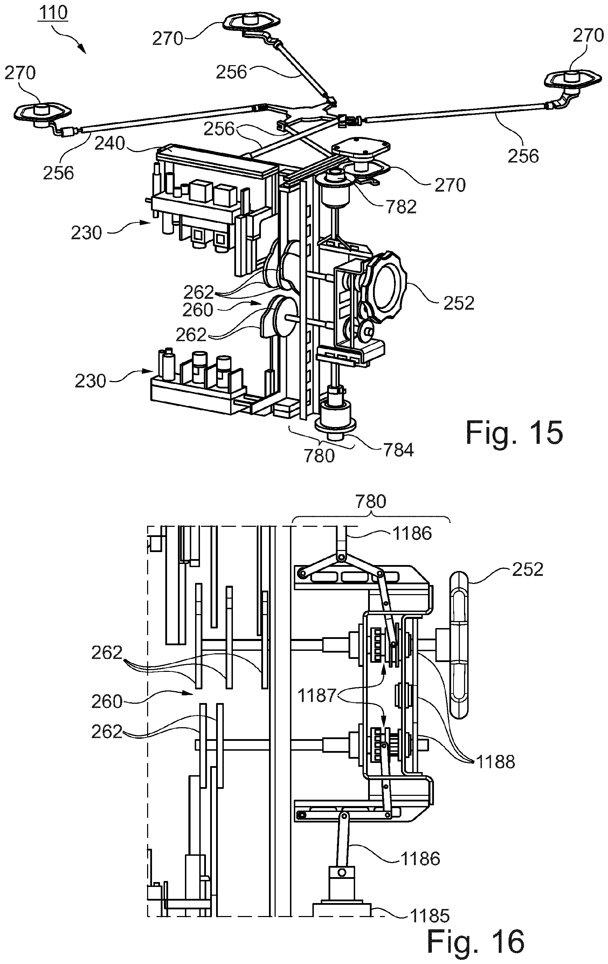

Fig. 15 zeigt das in Fig. 10 unten dargestellte Funktionsmodul 110 ohne Gehäuse. Dabei sind von dem Funktionsmodul 110 in der Darstellung von Fig. 15 die zwei Schnittstelleneinheiten 230, einer der Schutzdeckel 240, das Betätigungselement 252, das Gestänge 256, der Übertragungsabschnitt 260, die Kurvenscheiben 262 bzw. Kulissenscheiben an den zwei Wellen, vier Aufnahmeabschnitte 270, die Kupplungseinheit 780, der erste Druckbolzen 782 und der zweite Druckbolzen 784 gezeigt und explizit bezeichnet.

Fig. 16 zeigt einen Teilabschnitt des Funktionsmoduls 110 aus Fig. 15. Dabei sind von dem Funktionsmodul 110 in dem in Fig. 16 gezeigten Teilabschnitt das Betätigungselement 252, der Übertragungsabschnitt 260, die Kurvenscheiben 262, die Kupplungseinheit 780, eine der Führungsbuchsen 1185, die Hebel 1186, die Kupplungsstellen 1187 und die Zahnräder 1188 dargestellt.

Unter Bezugnahme auf die vorstehend genannten Figuren werden nachfolgend Ausführungsbeispiele zusammenfassend und mit anderen Worten erläutert.

Von außerhalb des Gehäuses 220 sind lediglich das Betätigungselement 252 und die Aufnahmeabschnitte 270, optional die Druckbolzen 782 und 784, sowie der zumindest eine Schutzdeckel 240 in der Verschlussstellung oder die zumindest eine Schnittstelleneinheit 230 in der ausgefahrenen Stellung sichtbar und/oder zugreifbar.

Die Drehbewegung des Hebels bzw. Betätigungselements 252 wird auf eine oder mehrere Kulissenscheiben bzw. Kurvenscheiben 262 übertragen, welche die radiale Bewegung in eine lineare Bewegung, horizontal und/oder vertikal, umwandeln. Je nach Ausprägung der Kulisse bzw. Kurvensteuerung bleibt eine damit verbundene mechanische Baugruppe bzw. zumindest ein Abtriebselement stehen und/oder bewegt sich vor bzw. zurück. Dadurch wird beim Kuppelvorgang zunächst das Klemmelement 245 bzw. ein Keil, welcher den Schutzdeckel 240 zur Abdichtung an das Gehäuse 220 drückt, weggefahren. Danach bewegt sich der Schutzdeckel 240 weg und gleichzeitig wird der Stecker Beziehung weise die Schnittstelleneinheit 230 in Position gefahren. Dieser Schritt ist für die Steckerkupplung an der Ober- und Unterseite des Gehäuses 220 gleich. Als letzten Schritt wird die Schnittstelleneinheit 230 an der Oberseite nach oben in das entsprechende Gegenstück gefahren. Um ein Wegdrücken des Gegensteckers bzw. der weiteren Schnittstelleneinheit 230 des weiteren Funktionsmoduls 110 zu verhindern, wird zudem über einen Bajonettverschluss, der durch die Aufnahmeabschnitte 270 und die Füße 1375 realisiert wird, ein mechanisches Verriegeln der zu verbindenden Funktionsmodule 110 erreicht, welches auch an die Drehbewegung des Betätigungselements 252 gekoppelt ist. Der ganze Vorgang findet statt, während die Gehäuse 220 aufeinander stehen und insbesondere über eine Lamellendichtung im Bereich der Dichtung bzw. der jeweils gegenüberliegenden Schnittstellenöffnungen 225 bereits einen dichten Kanal bilden. Hierbei kann zumindest ein Dichtungselement vorgesehen sein, das im Bereich der zumindest einen Schnittstellenöffnung 225 an dem Gehäuse 220 und/oder an dem Schutzdeckel 240 angeordnet sein kann. Das zumindest eine Dichtungselement kann als eine Schleusendichtung, als eine Lamellendichtung und/oder als eine EMV-Dichtung ausgeführt sein. Zusätzlich wird optional durch die Kupplungseinheit 780, insbesondere über die Druckbolzen 782 und 784 und einen Hebelmechanismus mit den Hebeln 1186 an der Ober- bzw. Unterseite die Drehbewegung entsprechend ein- oder ausgekuppelt. Somit kann ein Entfernen der Schutzabdeckung bzw. Schutzdeckel 240 ohne darüber-/darunterliegendes Gegenstück und somit in einen ungeschützten Bereich oder gar in den Boden verhindert werden.

Es wird für Funktionsmodule 110 ein Steckerkupplungssystem bereitgestellt, welches das Zusammenführen zweier Stecker bzw. Schnittstelleneinheiten 230 in einem möglichst hohem Automatisierungsgrad ermöglicht und zugleich die Anforderungen insbesondere der Militärnorm MIL-STD 810 hinsichtlich Umweltbedingungen erfüllen kann. Dieses Steckerkupplungssystem umfasst beispielsweise eine Steckverbindung als Anbaugehäuse mit zwei Steckverbindern bzw. Schnittstelleneinheiten 230 - einer Male-Steckverbindung und einer Female-Steckverbindung - eine automatische Abdeckung durch die Schutzdeckel 240, wobei in einem gekuppelten Zustand mindestens der Schutzgrad IP54 und in einem ungekuppelten Zustand mindestens der Schutzgrad IP54 erreicht werden kann, wobei durch eine zusätzliche, manuelle Verriegelung mindestens der Schutzgrad IP65 erreicht werden kann, ein automatisches Öffnen der Steckverbinder-Abdeckung bzw. der Schutzdeckel 240, ein manuelles Zusammenführen von Buchsen und Steckerteil, eine sequenzielle Kontaktierung von PE-, Leistungs- und Kommunikationskontakten und eine mögliche alleinstehende Steckverbindung ohne Anbaugehäuse über einen Adapter, etc.

Anders ausgedrückt umfasst dieses Steckerkupplungssystem insbesondere einen Drehhebel bzw. ein Drehrad als Betätigungselement 252, eine Welle mit Kurvensteuerung zur Verriegelung der Füße 1375 in den Aufnahmeabschnitten 270, zum Öffnen/Schließen der Abdeckungen bzw. Schutzdeckel 240 und zum Verfahren der Stecker bzw. Schnittstelleneinheiten 230, wobei die obere Schnittstelleneinheit 230 eines unten gestapelten Funktionsmoduls 110 in das Gehäuse 220 eines darüber gestalteten Funktionsmoduls 110 fährt, wobei ein manueller Verbindungsstecker mechanisch wie die Umweltklappe bzw. Schutzdeckel 240 angebunden wird, beinhaltet weiblichen Steckkontakt, ferner eine Blockade der oberen Schließmechanik der Mechanikeinheit 250, wenn kein weiteres Funktionsmodul 110 auf dem betrachteten Funktionsmodul gestapelt ist, eine Blockade der unteren Schließmechanik der Mechanikeinheit 250, wenn kein weiteres Funktionsmodul 110 unter dem betrachteten Funktionsmodul 110 gestapelt ist, eine konstruktive Anpassung der Füße 1375, wobei Schmutz von alleine abfallen soll (gröber, größer und offener), zudem ein Schutzdeckel 240 bzw. eine Umweltklappe auch unten an der unteren Schnittstellenöffnung 225 (BTuLB = Betriebs-, Transport und Lagerbehälter; versetzt bei Transport, zusätzliche Füße), wobei die untere Schnittstelleneinheit 230 nicht verfahren wird, und ferner eine Schleusendichtung für den oberen Schutzdeckel 240, insbesondere für eine EMV-Dichtung auf dem Gehäuse 220, sowie eine Schleusendichtung für den unteren Schutzdeckel 240 für eine EMV-Dichtung der Schließmechanik.

Umfasst ein Ausführungsbeispiel eine "und/oder"-Verknüpfung zwischen einem ersten Merkmal und einem zweiten Merkmal, so ist dies so zu lesen, dass das Ausführungsbeispiel gemäß einer Ausführungsform sowohl das erste Merkmal als auch das zweite Merkmal und gemäß einer weiteren Ausführungsform entweder nur das erste Merkmal oder nur das zweite Merkmal aufweist.

## Patentansprüche

1. Funktionsmodul (110) für ein modulares System (100), wobei das System (100) zumindest zwei Funktionsmodule (110) aufweist, die aufeinander und/oder nebeneinander gestapelt anordenbar oder angeordnet sind, wobei das Funktionsmodul (110) folgende Merkmale aufweist:
ein Gehäuse (220) mit zumindest einer Schnittstellenöffnung (225);
zumindest eine Schnittstelleneinheit (230), wobei die zumindest eine Schnittstelleneinheit (230) in dem Gehäuse (220) benachbart zu der zumindest einen Schnittstellenöffnung (225) angeordnet ist, wobei die zumindest eine Schnittstelleneinheit (230) elektrisch, optisch, fluidisch und/oder informationstechnisch mit zumindest einer in dem Gehäuse (220) angeordneten Funktionseinheit verbunden ist, wobei die zumindest eine Schnittstelleneinheit (230) ausgeformt ist, um mit einer weiteren Schnittstelleneinheit (230) eines weiteren Funktionsmoduls (110) des Systems (100) koppelbar zu sein, um eine elektrische, optische, fluidische und/oder informationstechnische Verbindung zu der weiteren Schnittstelleneinheit (230) herzustellen;
zumindest einen Schutzdeckel (240), der zwischen einer Verschlussstellung, in welcher die zumindest eine Schnittstellenöffnung (225) des Gehäuses (220) durch den zumindest einen Schutzdeckel (240) verschlossen ist, und einer Öffnungsstellung, in welcher die zumindest eine Schnittstellenöffnung (225) geöffnet ist, bewegbar angeordnet ist; und
eine Mechanikeinheit (250) mit einem von außerhalb des Gehäuses (220) zugreifbaren Betätigungselement (252) und einem Übertragungsabschnitt (260), wobei die Mechanikeinheit (250) ausgebildet ist, um eine Bewegung des Betätigungselements (252) über den Übertragungsabschnitt (260) auf zumindest ein Abtriebselement zu übertragen, wobei das zumindest eine Abtriebselement mindestens den zumindest einen Schutzdeckel (240) umfasst, wobei die Mechanikeinheit (250) ausgebildet ist, um eine Bewegung des Betätigungselements (252) über den Übertragungsabschnitt (260) auf den zumindest einen Schutzdeckel (240) zu übertragen, um den zumindest einen Schutzdeckel (240) zwischen der Verschlussstellung und der Öffnungsstellung zu bewegen.

2. Funktionsmodul (110) gemäß Anspruch 1, **dadurch gekennzeichnet, dass** die Mechanikeinheit (250) ausgebildet ist, um eine Drehbewegung des Betätigungselements (252) über den Übertragungsabschnitt (260) in eine translatorische Bewegung des zumindest einen Abtriebselements umzusetzen.

3. Funktionsmodul (110) gemäß einem der vorangegangenen Ansprüche, **dadurch gekennzeichnet, dass** der Übertragungsabschnitt (260) der Mechanikeinheit (250) als ein Kurvengetriebe mit zumindest einer Kurvenscheibe (262) oder Kulissenscheibe mit einer eine Steuerkurve (564) aufweisenden Nut (566) zum Führen eines Führungsstiftes (458) der Mechanikeinheit (250) ausgeführt ist.

4. Funktionsmodul (110) gemäß einem der vorangegangenen Ansprüche, **dadurch gekennzeichnet, dass** die Mechanikeinheit (250) zumindest ein Führungselement (254) zum Führen des zumindest einen Abtriebselements entlang zumindest einer Bewegungsachse aufweist, und/oder wobei die Mechanikeinheit (250) ein Gestänge (256) aufweist, das mit dem Übertragungsabschnitt (260) und mit dem zumindest einen Abtriebselement gekoppelt ist.

5. Funktionsmodul (110) gemäß einem der vorangegangenen Ansprüche, **dadurch gekennzeichnet, dass** das zumindest eine Abtriebselement die zumindest eine Schnittstelleneinheit (230) umfasst, wobei die Schnittstelleneinheit (230) zwischen einer eingefahrenen Stellung, in der die zumindest eine Schnittstelleneinheit (230) in das Gehäuse (220) eingefahren ist, und einer ausgefahrenen Stellung, in der die zumindest eine Schnittstelleneinheit (230) durch die zumindest eine Schnittstellenöffnung (225) hindurch zumindest teilweise aus dem Gehäuse (220) ausgefahren ist, bewegbar angeordnet ist, wobei die Mechanikeinheit (250) ausgebildet ist, um eine Bewegung des Betätigungselements (252) über den Übertragungsabschnitt (260) auf die zumindest eine Schnittstelleneinheit (230) zu übertragen, um die zumindest eine Schnittstelleneinheit (230) zwischen der eingefahrenen Stellung und der ausgefahrenen Stellung zu bewegen.

6. Funktionsmodul (110) gemäß einem der vorangegangenen Ansprüche, **gekennzeichnet durch** eine Mehrzahl von Füßen (1375) an einer Standflächenseite des Gehäuses (220) und durch eine Mehrzahl von Aufnahmeabschnitten (270) an einer von der Standflächenseite abgewandten Oberseite des Gehäuses (220) zum partiellen Aufnehmen weiterer Füße (1375) eines weiteren Funktionsmoduls (110) des Systems (100), wobei das zumindest eine Abtriebselement die Aufnahmeabschnitte (270) umfasst, die zwischen einer entriegelten Stellung, in der die weiteren Füße (1375) relativ zu den Aufnahmeabschnitten (270) bewegbar sind, und einer verriegelten Stellung, in der die weiteren Füße (1375) in den Aufnahmeabschnitten (270) verriegelt sind, bewegbar angeordnet sind, wobei die Mechanikeinheit (250) ausgebildet ist, um eine Bewegung des Betätigungselements (252) über den Übertragungsabschnitt (260) auf die Aufnahmeabschnitte (270) zu übertragen, um die Aufnahmeabschnitte (270) zwischen der entriegelten Stellung und der verriegelten Stellung zu bewegen.

7. Funktionsmodul (110) gemäß einem der vorangegangenen Ansprüche, **gekennzeichnet durch** zumindest ein Klemmelement (245) zum Festklemmen des zumindest einen Schutzdeckels (240) gegen das Gehäuse (220) in der Verschlussstellung, wobei das zumindest eine Klemmelement (245) zwischen einer Klemmstellung, in der das zumindest eine Klemmelement (245) in Anlage gegen den zumindest einen Schutzdeckel (240) angeordnet ist, und einer Freigabestellung, in der das zumindest eine Klemmelement (245) von dem zumindest einen Schutzdeckel (240) beabstandet angeordnet ist, bewegbar angeordnet ist, wobei die Mechanikeinheit (250) ausgebildet ist, um eine Bewegung des Betätigungselements (252) über den Übertragungsabschnitt (260) auf das zumindest eine Klemmelement (245) zu übertragen, um das zumindest eine Klemmelement (245) zwischen der Klemmstellung und der Freigabestellung zu bewegen.

8. Funktionsmodul (110) gemäß einem der vorangegangenen Ansprüche, **dadurch gekennzeichnet, dass** das Funktionsmodul (110) zumindest ein erstes Abtriebselement (230, 240, 245, 270) und zumindest ein zweites Abtriebselement (240, 245) aufweist, wobei das zumindest eine erste Abtriebselement (230, 240, 245, 270) im Bereich einer ersten Hauptoberfläche des Gehäuses (220) angeordnet ist, an der ein weiteres Funktionsmodul (110) des Systems (100) auf dem Funktionsmodul (110) gestapelt anordenbar oder angeordnet ist, wobei das zumindest eine zweite Abtriebselement (240, 245) im Bereich einer von der ersten Hauptoberfläche abgewandten zweiten Hauptoberfläche des Gehäuses (220) angeordnet ist, an der das Funktionsmodul (110) auf einem weiteren Funktionsmodul (110) des Systems (100) gestapelt anordenbar oder angeordnet ist.

9. Funktionsmodul (110) gemäß Anspruch 8, **gekennzeichnet durch** eine Kupplungseinheit (780), die mechanisch zwischen das Betätigungselement (252) und den Übertragungsabschnitt (260) der Mechanikeinheit (250) geschaltet ist, wobei die Kupplungseinheit (780) ausgebildet ist, um das Betätigungselement (252) und den Übertragungsabschnitt (260) abhängig davon, ob auf dem Funktionsmodul (110) ein weiteres Funktionsmodul (110) des Systems (100) gestapelt angeordnet ist und/oder das Funktionsmodul (110) auf einem weiteren Funktionsmodul (110) des Systems (100) gestapelt angeordnet ist, miteinander zu koppeln, um die Bewegung des Betätigungselements (252) auf das zumindest eine erste Abtriebselement und/oder auf das zumindest eine zweite Abtriebselement zu übertragen.

10. Funktionsmodul (110) gemäß Anspruch 9, **dadurch gekennzeichnet, dass** die Kupplungseinheit (780) einen ersten Druckbolzen (782), der durch ein auf dem Funktionsmodul (110) gestapelt angeordnetes weiteres Funktionsmodul (110) des Systems (100) verschiebbar ist, um die Kupplungseinheit (780) zu betätigen, und einen zweiten Druckbolzen (784) aufweist, der durch ein weiteres Funktionsmodul (110) des Systems (100), auf dem das Funktionsmodul (110) gestapelt ist, verschiebbar ist, um die Kupplungseinheit (780) zu betätigen.

11. Funktionsmodul (110) gemäß einem der vorangegangenen Ansprüche, **gekennzeichnet durch** zumindest ein Dichtungselement, das im Bereich der zumindest einen Schnittstellenöffnung (225) an dem Gehäuse (220) und/oder an dem Schutzdeckel (240) angeordnet ist, wobei das zumindest eine Dichtungselement als eine Schleusendichtung, als eine Lamellendichtung und/oder als eine EMV-Dichtung ausgeführt ist.

12. Modulares System (100), wobei das modulare System (100) zumindest zwei Funktionsmodule (110) aufweist, die aufeinander und/oder nebeneinander gestapelt anordenbar oder angeordnet sind, wobei jedes der Funktionsmodule (110) ein Funktionsmodul (110) gemäß einem der vorangegangenen Ansprüche ist.

13. System (100) gemäß Anspruch 12, **dadurch gekennzeichnet, dass** die Schnittstelleneinheiten (230) der Funktionsmodule (110) eine einheitliche Bauform aufweisen.

14. System (100) gemäß einem der Ansprüche 12 bis 13, **dadurch gekennzeichnet, dass** die Funktionsmodule (110) eine einheitliche Bauform mit einer einheitlichen Grundfläche und/oder zumindest einer einheitlichen Abmessung aufweisen.

## Claims

1. Functional module (110) for a modular system (100), wherein the system (100) comprises at least two functional modules (110) which can be arranged or are arranged stacked on top of one another and/or next to one another, wherein the functional module (110) comprises:
a housing (220) with at least one interface opening (225);
at least one interface unit (230), wherein the at least one interface unit (230) is arranged in the housing (220) adjacent to the at least one interface opening (225), wherein the at least one interface unit (230) is electrically, optically, fluidically and/or information-technologically connected to at least one functional unit arranged in the housing (220), wherein the at least one interface unit (230) is formed to be coupleable to a further interface unit (230) of a further functional module (110) of the system (100) in order to establish an electrical, optical, fluidic and/or information technology connection to the further interface unit (230);
at least one protective cover (240) which is arranged such that it can be moved between a closed position, in which the at least one interface opening (225) of the housing (220) is closed by the at least one protective cover (240), and an open position, in which the at least one interface opening (225) is open; and
a mechanic unit (250) having an actuating member (252) accessible from outside the housing (220) and a transmission portion (260), wherein the mechanic unit (250) is configured to transmit movement of the actuating member (252) to at least one output member via the transmission portion (260), wherein the at least one output element comprises at least the at least one protective cover (240), wherein the mechanic unit (250) is configured to transmit movement of the actuating element (252) via the transmission portion (260) to the at least one protective cover (240) in order to move the at least one protective cover (240) between the closed position and the open position.

2. Functional module (110) according to claim 1, **characterized in that** the mechanic unit (250) is configured to convert rotational movement of the actuating element (252) into translational movement of the at least one output element via the transmission portion (260).

3. Functional module (110) according to one of the preceding claims, **characterized in that** the transmission portion (260) of the mechanic unit (250) is configured as a cam mechanism with at least one cam plate (262) or link plate with a groove (566) having a control cam (564) for guiding a guide pin (458) of the mechanic unit (250).

4. Functional module (110) according to any one of the preceding claims, **characterized in that** the mechanic unit (250) comprises at least one guide element (254) for guiding the at least one output element along at least one axis of movement, and/or wherein the mechanic unit (250) comprises a linkage (256) coupled to the transmission portion (260) and to the at least one output element.

5. Functional module (110) according to any one of the preceding claims, **characterized in that** said at least one output element comprises said at least one interface unit (230), wherein said interface unit (230) is coupled between a retracted position, in which said at least one interface unit (230) is retracted into said housing (220), and an extended position, in which the at least one interface unit (230) is at least partially extended from the housing (220) through the at least one interface opening (225), wherein the mechanic unit (250) is configured to transmit movement of the actuator (252) to the at least one interface unit (230) via the transmission portion (260) to move the at least one interface unit (230) between the retracted position and the extended position.

6. Functional module (110) according to any one of the preceding claims, **characterized by** a plurality of feet (1375) on a standing surface side of the housing (220) and by a plurality of receiving portions (270) on an upper side of the housing (220) facing away from the standing surface side for partially receiving further feet (1375) of a further functional module (110) of the system (100), wherein the at least one output member comprises the receiving portions (270) which are movable between an unlocked position, in which the further feet (1375) are movable relative to the receiving portions (270), and a locked position, in which the further feet (1375) are locked in the receiving portions (270), wherein the mechanic unit (250) is configured to transmit movement of the actuating member (252) to the receiving portions (270) via the transmission portion (260) to move the receiving portions (270) between the unlocked position and the locked position.

7. Functional module (110) according to any one of the preceding claims, **characterized by** at least one clamping element (245) for clamping said at least one protective cover (240) against said housing (220) in said locked position, wherein said at least one clamping element (245) is movable between a clamping position, in which said at least one clamping element (245) is arranged in abutment against said at least one protective cover (240), and a release position, in which the at least one clamping element (245) is arranged spaced from the at least one protective cover (240), wherein the mechanic unit (250) is configured to transmit movement of the actuating element (252) to the at least one clamping element (245) via the transmission portion (260) in order to move the at least one clamping element (245) between the clamping position and the release position.

8. Functional module (110) according to any one of the preceding claims, **characterized in that** the functional module (110) comprises at least one first output element (230, 240, 245, 270) and at least one second output element (240, 245), wherein the at least one first output element (230, 240, 245, 270) is arranged in the region of a first main surface of the housing (220), on which a further functional module (110) of the system (100) can be arranged or is arranged in a stacked manner on the functional module (110), wherein the at least one second output element (240, 245) is arranged in the region of a second main surface facing away from the first main surface of the housing (220) on which the functional module (110) can be arranged or is arranged in a stacked manner on a further functional module (110) of the system (100).

9. Functional module (110) according to claim 8, **characterized by** a coupling unit (780) mechanically connected between the operating member (252) and the transmission portion (260) of the mechanic unit (250), wherein the coupling unit (780) is configured to connect the operating member (252) and the transmission portion (260) depending on whether a further functional module (110) of the system (100) is stacked on the functional module (110) and/or the functional module (110) is stacked on a further functional module (110) of the system (100), in order to transmit movement of the actuating element (252) to the at least one first output element and/or to the at least one second output element.

10. Functional module (110) according to claim 9, **characterized in that** the coupling unit (780) comprises a first pressure pin (782) displaceable by a further functional module (110) of the system (100) stacked on the functional module (110) to actuate the coupling unit (780), and a second pressure pin (784) displaceable by a further functional module (110) of the system (100) on which the functional module (110) is stacked to actuate the coupling unit (780).

11. Functional module (110) according to any one of the preceding claims, **characterised by** at least one sealing element arranged in the region of the at least one interface opening (225) on the housing (220) and/or on the protective cover (240), wherein the at least one sealing element is configured as a sluice seal, as a lamella seal and/or as an EMC seal.

12. Modular system (100), wherein the modular system (100) comprises at least two functional modules (110) which can be arranged or are arranged stacked on top of each other and/or next to each other, wherein each of the functional modules (110) is a functional module (110) according to one of the preceding claims.

13. System (100) according to claim 12, **characterized in that** the interface units (230) of the functional modules (110) have a uniform design.

14. System (100) according to any one of claims 12 to 13, **characterized in that** the functional modules (110) have a uniform design with a uniform footprint and/or at least one uniform dimension.

## Revendications

1. Module fonctionnel (110) pour un système modulaire (100), le système (100) présentant au moins deux modules fonctionnels (110) qui peuvent être disposés ou sont disposés empilés l'un sur l'autre et/ou l'un à côté de l'autre, le module fonctionnel (110) présentant les caractéristiques suivantes :
un boîtier (220) avec au moins une ouverture d'interface (225) ;
au moins une unité d'interface (230), l'au moins une unité d'interface (230) étant disposée dans le boîtier (220) au voisinage de l'au moins une ouverture d'interface (225), l'au moins une unité d'interface (230) étant reliée électriquement, optiquement, fluidiquement et/ou par des techniques d'information à au moins une unité fonctionnelle disposée dans le boîtier (220), ladite au moins une unité d'interface (230) étant formée pour pouvoir être couplée à une autre unité d'interface (230) d'un autre module fonctionnel (110) du système (100) afin d'établir une connexion électrique, optique, fluidique et/ou d'information avec ladite autre unité d'interface (230) ;
au moins un couvercle de protection (240), qui est disposé de manière mobile entre une position de fermeture, dans laquelle l'au moins une ouverture d'interface (225) du boîtier (220) est fermée par l'au moins un couvercle de protection (240), et une position d'ouverture, dans laquelle l'au moins une ouverture d'interface (225) est ouverte ; et
une unité mécanique (250) comprenant un élément d'actionnement (252) accessible depuis l'extérieur du boîtier (220) et une section de transmission (260), l'unité mécanique (250) étant conçue pour transmettre un mouvement de l'élément d'actionnement (252) à au moins un élément de sortie via la section de transmission (260), ledit au moins un élément de sortie comprenant au moins ledit au moins un couvercle de protection (240), ladite unité mécanique (250) étant adaptée pour transmettre un mouvement dudit élément d'actionnement (252) via ladite section de transmission (260) audit au moins un couvercle de protection (240) afin de déplacer ledit au moins un couvercle de protection (240) entre ladite position de fermeture et ladite position d'ouverture.

2. Module fonctionnel (110) selon la revendication 1, **caractérisé en ce que** l'unité mécanique (250) est configurée pour convertir un mouvement de rotation de l'élément d'actionnement (252) en un mouvement de translation de l'au moins un élément de sortie via la section de transmission (260).

3. Module fonctionnel (110) selon l'une des revendications précédentes, **caractérisé en ce que** la section de transmission (260) de l'unité mécanique (250) est réalisée sous la forme d'un mécanisme à came avec au moins un disque à came (262) ou un disque à coulisse avec une rainure (566) présentant une came de commande (564) pour guider une tige de guidage (458) de l'unité mécanique (250).

4. Module fonctionnel (110) selon l'une des revendications précédentes, **caractérisé en ce que** l'unité mécanique (250) comprend au moins un élément de guidage (254) pour guider ledit au moins un élément de sortie le long d'au moins un axe de déplacement, et/ou dans lequel l'unité mécanique (250) comprend une tringlerie (256) couplée à la section de transmission (260) et audit au moins un élément de sortie.

5. Module fonctionnel (110) selon l'une quelconque des revendications précédentes, **caractérisé en ce que** ledit au moins un élément de sortie comprend ladite au moins une unité d'interface (230), ladite unité d'interface (230) pouvant être déplacée entre une position rétractée, dans laquelle ladite au moins une unité d'interface (230) est rétractée dans le boîtier (220), et une position déployée, dans laquelle la au moins une unité d'interface (230) est disposée de manière mobile à travers la au moins une ouverture d'interface (225) au moins partiellement étendue hors du boîtier (220), l'unité mécanique (250) étant adaptée pour transmettre un mouvement de l'élément d'actionnement (252) à la au moins une unité d'interface (230) via la section de transmission (260) pour déplacer la au moins une unité d'interface (230) entre la position rétractée et la position étendue.

6. Module fonctionnel (110) selon l'une des revendications précédentes, **caractérisé par** une pluralité de pieds (1375) sur un côté de surface d'appui du boîtier (220) et par une pluralité de parties de réception (270) sur un côté supérieur du boîtier (220) opposé au côté de surface d'appui pour recevoir partiellement d'autres pieds (1375) d'un autre module fonctionnel (110) du système (100), ledit au moins un élément de sortie comprenant lesdites parties de réception (270) qui peuvent être déplacées entre une position déverrouillée, dans laquelle les autres pieds (1375) sont mobiles par rapport aux sections de réception (270), et une position verrouillée dans laquelle les autres pieds (1375) sont verrouillés dans les sections de réception (270), l'unité mécanique (250) étant adaptée pour transmettre un mouvement de l'élément d'actionnement (252) aux sections de réception (270) par l'intermédiaire de la section de transmission (260) afin de déplacer les sections de réception (270) entre la position déverrouillée et la position verrouillée.

7. Module fonctionnel (110) selon l'une quelconque des revendications précédentes, **caractérisé par** au moins un élément de serrage (245) pour serrer ledit au moins un couvercle de protection (240) contre le boîtier (220) dans la position de fermeture, ledit au moins un élément de serrage (245) étant déplacé entre une position de serrage, dans laquelle ledit au moins un élément de serrage (245) est disposé en appui contre ledit au moins un couvercle de protection (240), et une position de dégagement, dans laquelle l'au moins un élément de serrage (245) est disposé à distance de l'au moins un couvercle de protection (240), l'unité mécanique (250) étant adaptée pour transmettre un mouvement de l'élément d'actionnement (252) à l'au moins un élément de serrage (245) par l'intermédiaire de la section de transmission (260) afin de déplacer l'au moins un élément de serrage (245) entre la position de serrage et la position de relâchement.

8. Module fonctionnel (110) selon l'une des revendications précédentes, **caractérisé en ce que** le module fonctionnel (110) présente au moins un premier élément de sortie (230, 240, 245, 270) et au moins un deuxième élément de sortie (240, 245), ledit au moins un premier élément de sortie (230, 240, 245, 270) étant disposé dans la zone d'une première surface principale du boîtier (220), sur laquelle un autre module fonctionnel (110) du système (100) peut être disposé ou est disposé de manière empilée sur le module fonctionnel (110), l'au moins un deuxième élément de sortie (240, 245) étant disposé dans la zone d'une deuxième surface principale du boîtier (220) opposée à la première surface principale, sur laquelle le module fonctionnel (110) peut être disposé ou est disposé de manière empilée sur un autre module fonctionnel (110) du système (100).

9. Module fonctionnel (110) selon la revendication 8, **caractérisé par** une unité de couplage (780) connectée mécaniquement entre l'élément d'actionnement (252) et la section de transmission (260) de l'unité mécanique (250), l'unité de couplage (780) étant configurée pour coupler l'élément d'actionnement (252) et la section de transmission (260) en fonction de , si un autre module fonctionnel (110) du système (100) est disposé de manière empilée sur le module fonctionnel (110) et/ou si le module fonctionnel (110) est disposé de manière empilée sur un autre module fonctionnel (110) du système (100), de les coupler entre eux afin de transmettre le mouvement de l'élément d'actionnement (252) à l'au moins un premier élément de sortie et/ou à l'au moins un deuxième élément de sortie.

10. Module fonctionnel (110) selon la revendication 9, **caractérisé en ce que** l'unité d'accouplement (780) comprend un premier boulon de pression (782) qui peut être déplacé par un autre module fonctionnel (110) du système (100) disposé de manière empilée sur le module fonctionnel (110), pour actionner l'unité d'embrayage (780), et un deuxième boulon de pression (784) qui peut être déplacé par un autre module fonctionnel (110) du système (100) sur lequel le module fonctionnel (110) est empilé, pour actionner l'unité d'embrayage (780).

11. Module fonctionnel (110) selon l'une des revendications précédentes, **caractérisé par** au moins un élément d'étanchéité qui est disposé dans la zone de l'au moins une ouverture d'interface (225) sur le boîtier (220) et/ou sur le couvercle de protection (240), l'au moins un élément d'étanchéité étant réalisé sous la forme d'un joint d'étanchéité de sas, d'un joint d'étanchéité lamellaire et/ou d'un joint d'étanchéité CEM.

12. Système modulaire (100), le système modulaire (100) comprenant au moins deux modules fonctionnels (110) qui peuvent être disposés ou sont disposés empilés l'un sur l'autre et/ou l'un à côté de l'autre, chacun des modules fonctionnels (110) étant un module fonctionnel (110) selon l'une des revendications précédentes.

13. Système (100) selon la revendication 12, **caractérisé en ce que** les unités d'interface (230) des modules fonctionnels (110) présentent une forme de construction uniforme.

14. Système (100) selon l'une des revendications 12 à 13, **caractérisé en ce que** les modules fonctionnels (110) présentent une forme de construction uniforme avec une surface de base uniforme et/ou au moins une dimension uniforme.
